# EUROPEAN PATENT APPLICATION

(11) **EP 1 767 672 A1**
(43) Date of publication of application: **28.03.2007**
(21) Application number: 05743664.4
(22) Date of filing: 27.05.2005
(51) Int. Cl.: C25D 5/10, C23C 18/48

(54) **TIN-BASED PLATING FILM AND METHOD FOR FORMING THE SAME**

(30) Priority: 21.06.2004 JP 2004183078
(71) Applicant: Rambo Chemicals (H.K.) Ltd., Kwai Chung, N.T., Hong Kong SAR (CN); Okuno Chemical Industries Co. Ltd, Osaka-shi, Osaka 541-0045 (JP)
(72) Inventor: KWOK, Chun Wah, Jimmy, 4D/F., Block 14, Kowloon, Hong Kong SAR (CN); KWOK, Yim Wah, Rosaline, Flat 1A/F., Kowloon, Hong Kong SAR (CN); NAKAGISHI, Yutaka, OKUNO CHEMICAL IND. CO. LTD., Tsurumi-ku, Osaka-shi, Osaka 5380044 (JP)
(74) Representative: TBK-Patent
(86) International application number: PCT/JP2005/009784
(87) International publication number: WO 2005/123987

(57) **Abstract**

The present invention provides a tin-based two-layered plating film exhibiting suppressed whisker growth comprising a lower layer of a tin plating film or tin alloy plating film comprising 5 % by weight or less of at least one metal selected from the group consisting of cobalt, copper, bismuth, silver, and indium, and 95 % by weight or more of tin, and an upper layer of a tin plating film or tin alloy plating film comprising 5 % by weight or less of at least one metal selected from the group consisting of cobalt, copper, bismuth, silver and indium, and 95 % by weight or more of tin. The tin-based plating film of the present invention is a lead-free tin plating film or tin alloy plating film, exhibits suppressed whisker growth over an extended period, and can further be formed relatively easily without complicated steps.

## Description

### TECHNICAL FIELD

The present invention relates to a tin-based plating film with suppressed whisker growth, and a method for forming the same.

### BACKGROUND ART

Sn-Pb plating provides plating films with good appearance, outstanding solderbility, and allows relatively easy plating bath management, because of which it has been called solder plating and widely used for plating electrical and electronic components. In recent years, however, there are indications that solder has been leaching from electronic component wastes by acid rain, etc., becoming a contamination source for groundwater. Since lead, which is particularly harmful to the human body, causes problems in the work environment and waste water treatment, development of lead-free tin alloys has been urgently demanded.

Examples of known lead-free Sn alloy platings having good solderbility and low melting points are those containing Ag, Cu, In, Tl, Zn, and the like (see Patent document 1 below).

However, when plating films are formed using such lead-free tin alloy plating solutions, the obtained plating films are susceptible to formation of hair-like single crystals called "whiskers". Whiskers grown on plating films formed on electrical and electronic components cause shorting of circuits and terminals, resulting in significantly degraded performance and reliability of electrical and electronic components. For this reason, with plating films for electrical and electronic components, the prevention of such whisker formation has been an important object.

In light of the cost and cumbersome management of plating baths, electroplating with tin alone is advantageous; however since such plating cannot prevent short-circuiting on the plating surface caused by the whisker formation, it is not usually employed for plating electrical and electronic components as it is.

A known method of preventing tin and tin alloy whisker growth is to perform a melting treatment after plating. However, such melting treatment poses drawbacks in that it is expensive and unsuitable for use with complicated shapes, restricting the shapes of applicable items.

Another known method is to perform chemical posttreatment using a phosphoric acid solution after plating. However, when electronic components with tin or tin alloy plating films formed thereon are mass-produced, problems arise in that the posttreatment solution is liable to be contaminated, and once contaminated, performance of the plating film is deteriorated.
Patent document 1: Unexamined Japanese Patent Publication No. 1996-13185

### DISCLOSURE OF THE INVENTION

### PROBLEMS TO BE SOLVED BY THE INVENTION

The present invention has been accomplished in view of the above state of the art, and its primary object is to provide a tin-based plating film such as a lead-free tin plating film or tin alloy plating film which can suppress whisker growth for an extended period, and can be relatively easily formed without complicated steps.

### MEANS FOR SOLVING THE PROBLEMS

The present inventors have conducted extended research to accomplish the above object. As a result, the inventors have found that a two-layered tin-based plating film comprising a lower layer of a tin plating film or tin alloy plating film and an upper layer of relatively thin tin plating film or tin alloy plating film formed on the lower layer is capable of preventing the formation of whiskers for an extended period of time. The inventors have further found that when the alloy composition constituting the upper plating film layer is appropriately selected, reflow temperatures can be arbitrarily determined without affecting the properties of the plating film as a whole. The present invention has been accomplished based on these findings.

More specifically, the present invention provides the following tin-based plating films exhibiting suppressed whisker growth, and methods for forming them.
Item 1. A tin-based two-layered plating film exhibiting suppressed whisker growth comprising,
   a lower layer of a tin plating film or tin alloy plating film comprising 5 % by weight or less of at least one metal selected from the group consisting of cobalt, copper, bismuth, silver, and indium, and 95 % by weight or more of tin, and
   an upper layer of a tin plating film or tin alloy plating film comprising 5 % by weight or less of at least one metal selected from the group consisting of cobalt, copper, bismuth, silver and indium, and 95 % by weight or more of tin.
Item 2. A tin-based plating film of Item 1, wherein the lower layer has a film thickness of 0.1 to 20 µm, and the upper layer has a film thickness of 0.025 to 5 µm.
Item 3. A tin-based plating film of Item 1 or 2, wherein the lower layer is a matt or semi-bright tin plating film or tin alloy plating film, and the upper layer is a bright or semi-bright tin plating film or tin alloy plating film.
Item 4. A tin-based plating film of any one of Items 1 to 3, wherein the lower layer is a matt tin plating film, and the upper layer is a bright tin alloy plating film.
Item 5. A tin-based plating film of any one of Items 1 to 4 further comprising an undercoat plating layer under the lower layer of the tin-based two-layered plating film, the undercoat plating layer being:
   (1) a plating film of Ni or Cu,
   (2) a plating film of Sn, Sn-Co alloy, Sn-Cu alloy, Sn-Bi alloy, Sn-Ag alloy, or Sn-In alloy, or
   (3) a two-layered plating film consisting of the first layer of Ni or Cu, and the second layer of Sn, Sn-Co alloy, Sn-Cu alloy, Sn-Bi alloy, Sn-Ag alloy or Sn-In alloy formed on the first layer.
Item 6. A product comprising the tin-based plating film of any one of Items 1 to 5 formed on a substrate.
Item 7. A method for forming a tin-based plating film exhibiting suppressed whisker growth, the method comprising the steps of forming on a substrate by electro- or electroless plating a lower layer of a tin plating film or a tin alloy plating film comprising 5 % by weight or less of at least one metal selected from the group consisting of cobalt, copper, bismuth, silver, and indium, and 95 % by weight or more of tin, and subsequently forming by electro- or electroless plating an upper layer of a tin plating film or tin alloy plating film comprising 5 % by weight or less of at least one metal selected from the group consisting of cobalt, copper, bismuth, silver, and indium, and 95 % by weight or more of tin.
Item 8. A method for forming a tin-based plating film exhibiting suppressed whisker growth, the method comprising the steps of forming on a substrate by electro- or electroless plating a undercoat plating layer as a barrier layer, the undercoat plating layer being:
   (1) a plating film of Ni or Cu,
   (2) a plating film of Sn, Sn-Co alloy, Sn-Cu alloy, Sn-Bi alloy, Sn-Ag alloy, or Sn-In alloy, or
   (3) a two-layered plating film consisting of the first layer of Ni or Cu, and the second layer of Sn, Sn-Co alloy, Sn-Cu alloy, Sn-Bi alloy, Sn-Ag alloy or Sn-In alloy formed on the first layer,
   subsequently forming by the method of Item 7 a tin plating film or tin alloy plating film as a lower layer, and forming a tin plating film or tin alloy plating film as an upper layer.

The tin-based plating film of the present invention has a two-layer structure consisting of a lower layer: a tin plating film or tin alloy plating film comprising 5 % by weight or less of at least one metal selected from the group consisting of cobalt, copper, bismuth, silver, and indium, and 95 % by weight or more of tin; and an upper layer: a tin plating film or tin alloy plating film comprising 5 % by weight or less of at least one metal selected from the group consisting of cobalt, copper, bismuth, silver and indium, and 95 % by weight or more of tin.

With a tin-based film having such a two-layer structure, the formation of a very thin tin plating film or tin alloy plating film as an upper layer can prevent whisker growth for an extended period, regardless of whether the lower layer is a tin plating film or tin alloy plating film.

The upper plating layer and the lower plating layer may be of bright, semi-bright or matt (matted) finish, and suitable selections can be made in accordance with the purpose of use.

In particular, the lower layer is preferably a tin plating film. Further, the lower layer is preferably of semi-bright or matt, with matt being more preferable. Due to their large crystal grain sizes and great stress relief effects, semi-bright and matt tin plating films can effectively retard whisker growth. Even when the lower layer is a tin alloy plating film, whiskers are less likely to grow by the above-mentioned two-layer structure, and problems such as variation of reflow temperature, degradation of solderbility, occurrence of crackings, etc. hardly occur. Given this, compared with a single layer tin alloy plating film, such a two-layer structure can dispense with strict control of the alloy composition and makes the plating process easier.

The upper layer is preferably a bright or semi-bright finish tin plating film or tin alloy plating film, with a bright plating film being particularly preferable. Due to their small crystal grain sizes, bright and semi-bright plating films can block pores. Further, since such films are relatively hard, the film surface is scarcely scratched. With these characteristics, they can very effectively prevent the formation of whiskers.

When the lower layer is a semi-bright or matt tin or tin alloy plating film and the upper layer is a bright or semi-bright tin or tin alloy plating film, internal stress and crack occurrence can be suppressed without increasing the overall hardness. In particular, it is preferable that the lower layer be a matt tin plating film and the upper layer be a bright tin alloy plating film.

When forming a tin alloy plating film as the upper layer, the reflow temperature can be arbitrarily set by selecting the composition of the tin alloy, thereby easily providing a film having a reflow temperature meeting the purpose of use. Comparing such a structure with a film formed only by a tin alloy plating layer, since the tin alloy plating layer forming the upper layer is a thin film, the alloy composition is relatively stable and reflow temperatures can be easily controlled. Further, since such a structure requires an upper layer of tin alloy layer having an extremely thin film, only a reflow temperature can be freely controlled without adversely affecting the properties of the lower layer of tin plating film or tin alloy plating.

The upper layer of bright or semi-bright tin plating film or tin alloy plating film can be formed using a known tin plating bath or tin alloy plating bath containing, for example, a grain refiner and/or like additives.

The thickness of the lower layer of tin plating film or tin alloy plating film is not limited, but typically is preferably about 0.1 to about 20 µm. In particular, for plating connectors, the lower layer preferably has a thickness of about 1.5 to about 5 µm, and more preferably about 2.5 to about 5 µm. When plating IC components, lead frames, and the like, the lower layer preferably has a thickness of about 8 to about 20 µm, and more preferably about 10 to about 15 µm.

The thickness of the upper layer of tin plating film or tin alloy plating film is not limited, but it is preferable that it be thinner than the lower layer, with about 0.025 to 5 µm typically being preferable. The film thickness of the upper layer should preferably be within the above range, and at the same time be about 50 % or less, and more preferably about 25 % or less, of the film thickness of the lower layer.

The method(s) for forming tin plating and tin alloy plating films of the above-mentioned two-layered tin-based plating film is not limited, and desired tin and/or tin alloy plating films may be formed in a typical manner using conventionally known tin and/or tin alloy plating baths. Both electro- and electroless plating baths can be used.

Examples of electroplating baths are various known tin and tin alloy plating baths such as organic sulfonic acid bath, sulfuric acid bath, pyrophosphoric acid bath, tartaric acid bath, and the like. Specific compositions of these plating baths are not limited, and any compositions can be employed as long as they are able to form desired tin and tin alloy plating films.

Examples of the organic sulfonic acid baths include those containing methanesulfonic acid, ethanesulfonic acid, methanolsulfonic acid, ethanolsulfonic acid, phenolsulfonic acid, naphtholsulfonic acid, or the like. A composition for a methanesulfonic acid bath is given below as an example of a bath composition for a tin electroplating solution.

| | |
|---|---|
| Methanesulfonic acid | 100 to 250 ml/l |
| Tin methanesulfonate (as a 300 g/l aqueous solution) | 100 to 350 ml/l |
| Brightener | 0.1 to 2 g/l |
| Wetting agent | 30 to 1000 g/l |
| Additive (grain refiner) | 0.1 to 5 g/l |

When forming a tin alloy plating film, metal salts of methanesulfonic acid or the like containing metal components alloying with tin may further be added to the tin plating solution. For example, when forming a tin-cobalt alloy, cobalt methanesulfonate, and/or the like may be added in a range of about 20 mg/l to about 1500 mg/l on a metal concentration basis. The amount of metal salts to be added may be selected within such a range in accordance with the desired alloy composition.

Plating conditions are not limited; the bath temperature may be about 5 to about 65 °C, and the cathode current density may be about 1 to about 50 A/dm².

Alternatively, high speed plating such as hoop plating and jet plating, or pulse plating may be employed.

Pretreatment for forming tin or tin alloy plating films is not limited, and may be performed according to a typical manner.

For example, degreasing may be carried out in a typical manner, and as necessary, chemical polishing, etching, and like treatments may follow. A lower layer of tin or tin alloy plating film is subsequently formed, and an upper layer of tin or tin alloy plating film may be formed subsequently.

Between the above-mentioned two-layered tin-based plating film and substrate, an undercoat plating layer of Ni or Cu, or an undercoat plating layer of Sn, Sn-Co alloy, Sn-Cu alloy, Sn-Bi alloy, Sn-Ag alloy or Sn-In alloy, functioning as a barrier layer may be formed as necessary. Alternatively, after forming an undercoat plating layer of Ni or Cu, another undercoat plating layer of Sn, Sn-Co alloy, Sn-Cu alloy, Sn-Bi alloy, Sn-Ag alloy, or Sn-In alloy may be formed.

Among these, an undercoat plating layer of Ni or Cu preferably has a semi-bright or matt finish, which have larger crystal grain sizes. The formation of such an undercoat plating layer enhances the effect of stress relief. Further, such an undercoat plating layer, together with a substrate, forms metallic interlayer which can suppress whisker growth caused by internal stress from the substrate and migration stress from the substrate and the like. Such a Ni or Cu undercoat plating layer preferably has a film thickness of about 0.1 to about 10 µm, and more preferably about 0.1 to about 2 µm.

It is preferable that an undercoat plating layer of Sn, Sn-Co alloy, Sn-Cu alloy, Sn-Bi alloy, Sn-Ag alloy or Sn-In alloy be a bright or semi-bright plating film, which has smaller crystal grain sizes. The formation of such an undercoat plating layer is able to block micropores, thereby suppressing whisker growth. If the formation of a Ni plating layer as a barrier layer is not feasible due to the circumstances of the manufacturing equipment, assembly steps, and the like, a metallic interlayer is formed from such an undercoat plating layer and the substrate, and whisker growth caused by internal stress from the substrate and migration stress from the substrate and the like can be retarded. An undercoat plating layer of Sn, Sn-Co alloy, Sn-Cu alloy, Sn-Bi alloy, Sn-Ag alloy or Sn-In alloy preferably has a film thickness of about 0.01 to about 3 µm, and more preferably about 0.01 to about 1 µm. Further, it is preferable that tin be contained about 60 % by weight or more in an Sn-Co alloy, Sn-Cu alloy, Sn-Bi alloy, Sn-Ag alloy or Sn-In alloy.

The method for forming the undercoat plating layer as a barrier layer is not limited, and desired plating films may be formed using conventionally known plating baths in a typical manner. Both electro- and electroless plating baths can be used for this purpose.

Materials of an article to be plated are not limited as long as the aforementioned plating film can be formed thereon. Examples can include copper, copper alloy, iron, iron alloy, and the like. When electroplating non-conducting materials, the surface of the material is coated with a metal by electroless plating or the like to impart electric conductivity before electroplating is performed.

Kinds and shapes of the articles to be plated are not limited, and typical examples are electronic components which require soldering such as lead frames, semiconductor packages, chip components, and the like.

After the formation of a two-layered tin-based plating film by an above method(s), chemical posttreatment may further be applied as necessary.

Such chemical posttreatment may be performed following conventional methods, and examples include a method in which the plating film is immersed for about 5 to about 60 seconds in a solution containing about 30 to 70 g/l of trisodium phosphate at a temperature of about 30 to about 50 °C.

### EFFECTS OF THE INVENTION

In comparison with conventional plating films comprising a single tin or tin alloy layer, the two-layered tin-based plating film of the present invention can greatly suppress whisker formation, and thereby provide highly reliable electrical and electronic components.

In particular, with such a structure, when the upper layer is a tin alloy plating film, its thin film thickness stabilizes the alloy composition, contributing to easier control of reflow temperature. Further, since the film thickness of the tin alloy plating film is thin, the reflow temperature can be controlled without substantially affecting the characteristic properties of the lower layer plating film.

When the lower layer is a semi-bright or matt (non-bright) tin or tin alloy plating film, and a semi-bright or bright tin or tin alloy plating film is formed thereon, the presence of the thick semi-bright or matt lower layer contributes to overall stress relief, and further, the presence of the very hard surface layer can suppress the scratching formation, providing outstanding effects in preventing whisker growth.

### BRIEF DESCRIPTION OF THE DRAWINGS

[FIG. 1] A figure printed from the electronic data of an SEM image taken after a sample consisting of a tin-cobalt plating layer and a pure tin plating layer formed on a brass plate was allowed to stand at room temperature.
[FIG. 2] A figure printed from the electronic data of an SEM image taken after a sample consisting of a pure tin plating layer formed on a brass plate was allowed to stand at room temperature.
[FIG. 3] A figure printed from the electronic data of an SEM image of a plating film surface taken after a sample consisting of a tin-cobalt alloy plating layer and a matt tin plating layer formed on a phosphore bronze plate was allowed to stand at a high humidity and high temperature.

### BEST MODE FOR CARRYING OUT THE INVENTION

The present invention is further described in detail below with reference to examples.

### Example 1

Using as a substrate a 6.5 x 10 cm brass plate, electrolytic degreasing treatment was performed, and the plate was immersed in an aqueous acidic solution for one minute at ambient temperature as an activation treatment, followed by immersion in an aqueous solution containing a 70 % methanesulfonic acid solution in a concentration of 10 % by weight.

Subsequently, using a tin electroplating bath having the following composition, a bright tin plating film of about 3 µm thickness was formed.

### (Tin plating bath composition)

| | |
|---|---|
| Methanesulfonic acid | 175 ml/l |
| Tin methanesulfonate | 45 g/l (as tin metal amount) |
| Wetting agent | 100 g/l |
| Brightener | 0.3 g/l |
| Additive | 0.5 g/l |
| (grain refiner) | |

### (Plating conditions)

Bath temperature: room temperature
Cathode current density: 10 A/dm²
Plating time: 1 minute

Next, using a tin-cobalt electroplating bath having the following composition, a tin-cobalt plating film of about 1.25 µm thickness was then formed. The composition of the alloy plating film was 99.5 % by weight of tin and 0.5 % by weight of cobalt.

### (Tin-cobalt plating bath composition)

| | |
|---|---|
| Cobalt methanesulfonate | 400 mg/l (as cobalt metal amount) |
| Tin sulfate | 45 g/l (as tin metal amount) |
| 98 % H₂SO₄ | 100 ml/l |
| Wetting agent | 80 g/l |
| Brightener | 0.3 g/l |
| Additive | 0.5 g/l |
| (grain refiner) | |

### (Plating conditions)

Bath temperature: 15 °C
Cathode current density: 15 A/dm²
Plating time: 0.3 minutes

In accordance with the above methods, a two-layered tin-based plating film consisting of a pure tin plating layer of about 3 µm thickness and a tin-cobalt plating layer of 1.25 µm thickness was formed on a brass plate.

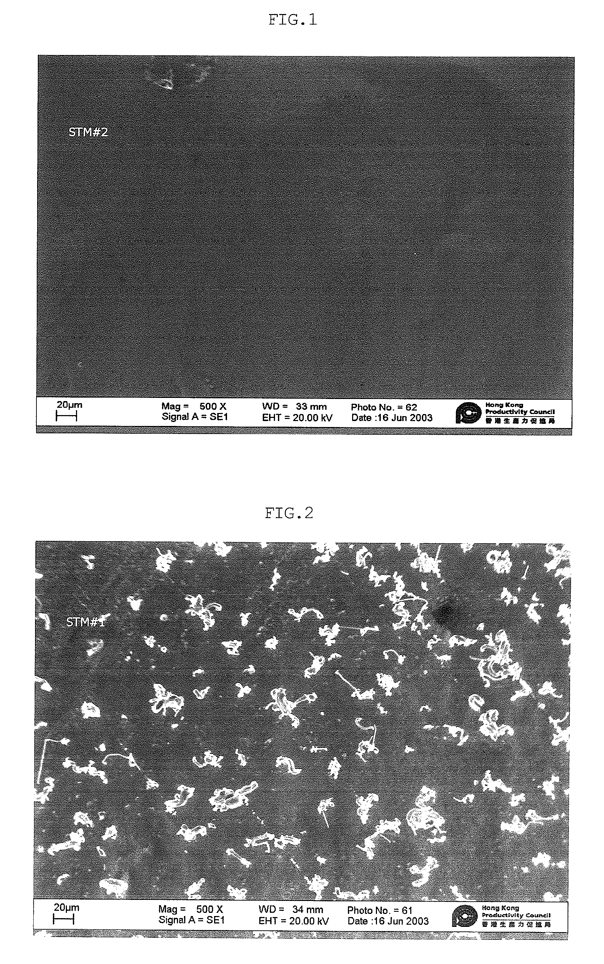

FIG. 1 shows an SEM image (500 x) of the plating film surface of the thus obtained sample which was allowed to stand at room temperature for 5 months.

For a comparison, FIG. 2 shows an SEM image (500 x) of the plating film surface of a sample comprising a pure tin plating film of 3 µm thickness formed on a brass plate in the same manner as the above which was allowed to stand at room temperature for 5 months.

As is clear from FIGS. 1 and 2, the sample with only a pure tin plating film (FIG. 2) had grown many whiskers after 5 months, while the sample with an extremely thin tin-cobalt plating layer formed on a pure tin plating layer (FIG. 1) had substantially no whisker growth after 5 months.

### Example 2

Using as a substrate a 6.5 x 10 cm phosphor bronze plate, pretreatment was performed in the same manner as in Example 1. Subsequently, a matt (non-bright) tin plating film of about 11 µm thickness was formed using a tin electroplating bath having the following composition.

### (Matt tin plating bath composition)

| | |
|---|---|
| Methanesulfonic acid | 175 ml/l |
| Tin methanesulfonate | 45 g/l (by tin metal amount) |
| Additive | 0.5 g/l |
| (grain refiner) | |

### (Plating conditions)

Bath temperature: room temperature
Cathode current density: 10 A/dm²
Plating time: 2.4 minutes

A tin-cobalt alloy plating layer of 1.25 µm thickness was then formed as the upper layer in the same manner as in Example 1.

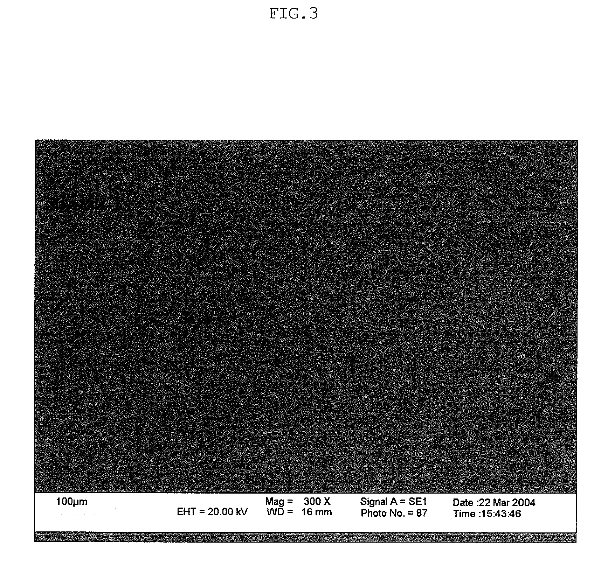

The thus obtained sample had a matt finish, however due to the presence of the upper tin-cobalt alloy plating layer having small crystal grain sizes and high hardness, the film surface had high hardness and is hence not liable to be scratched. FIG. 3 shows an SEM image (300 x) of the plating film surface of this sample taken after it was allowed to stand for 500 hours under high humidity and high temperature conditions at a humidity 85 % and a temperature of 85 °C. As is clear from the figure, the sample comprising the upper tin-cobalt alloy layer formed on the matt tin plating layer was confirmed to have an excellent whisker growth suppressing effect.

## Claims

1. A tin-based two-layered plating film exhibiting suppressed whisker growth comprising,
a lower layer of a tin plating film or tin alloy plating film comprising 5 % by weight or less of at least one metal selected from the group consisting of cobalt, copper, bismuth, silver, and indium, and 95 % by weight or more of tin, and
an upper layer of a tin plating film or tin alloy plating film comprising 5 % by weight or less of at least one metal selected from the group consisting of cobalt, copper, bismuth, silver and indium, and 95 % by weight or more of tin.

2. A tin-based plating film of claim 1, wherein the lower layer has a film thickness of 0.1 to 20 µm, and the upper layer has a film thickness of 0.025 to 5 µm.

3. A tin-based plating film of claim 1, wherein the lower layer is a matt or semi-bright tin plating film or tin alloy plating film, and the upper layer is a bright or semi-bright tin plating film or tin alloy plating film.

4. A tin-based plating film of claim 1, wherein the lower layer is a matt tin plating film, and the upper layer is a bright tin alloy plating film.

5. A tin-based plating film of claim 1 further comprising an undercoat plating layer under the lower layer of the tin-based two-layered plating film, the undercoat plating layer being:
(1) a plating film of Ni or Cu,
(2) a plating film of Sn, Sn-Co alloy, Sn-Cu alloy, Sn-Bi alloy, Sn-Ag alloy, or Sn-In alloy, or
(3) a two-layered plating film consisting of the first layer of Ni or Cu, and the second layer of Sn, Sn-Co alloy, Sn-Cu alloy, Sn-Bi alloy, Sn-Ag alloy or Sn-In alloy formed on the first layer.

6. A product comprising the tin-based plating film of any one of claims 1 to 5 formed on a substrate.

7. A method for forming a tin-based plating film exhibiting suppressed whisker growth, the method comprising the steps of forming on a substrate by electro- or electroless plating a lower layer of a tin plating film or a tin alloy plating film comprising 5 % by weight or less of at least one metal selected from the group consisting of cobalt, copper, bismuth, silver, and indium, and 95 % by weight or more of tin, and subsequently forming by electro- or electroless plating an upper layer of a tin plating film or tin alloy plating film comprising 5 % by weight or less of at least one metal selected from the group consisting of cobalt, copper bismuth, silver, and indium, and 95 % by weight or more of tin.

8. A method for forming a tin-based plating film exhibiting suppressed whisker growth, the method comprising the steps of forming on a substrate by elector- or electroless plating a undercoat plating layer as a barrier layer, the undercoat plating layer being:
(1) a plating film of Ni or Cu,
(2) a plating film of Sn, Sn-Co alloy, Sn-Cu alloy, Sn-Bi alloy, Sn-Ag alloy, or Sn-In alloy, or
(3) a two-layered plating film consisting of the first layer of Ni or Cu, and the second layer of Sn, Sn-Co alloy, Sn-Cu alloy, Sn-Bi alloy, Sn-Ag alloy or Sn-In alloy formed on the first layer,
subsequently forming by the method of claim 7 a tin plating film or tin alloy plating film as a lower layer, and forming a tin plating film or tin alloy plating film as an upper layer.
